# EUROPEAN PATENT SPECIFICATION

(11) **EP 0 438 127 B1**
(45) Date of publication and mention of the grant of the patent: **07.12.1994**
(21) Application number: 91100434.9
(22) Date of filing: 16.01.1991
(51) Int. Cl.: H01L 21/66

(54) **Semiconductor wafer**
Halbleiterscheibe
Plaquette semi-conductrice

(30) Priority: 19.01.1990 JP 9582/90
(43) Date of publication of application: 24.07.1991
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Sakumoto, Aiichiro, c/o Intellectual Property Div., Minato-ku, Tokyo 105 (JP); Kawakami, Michihiro, c/o Intellectual Prop. Div., Minato-ku, Tokyo 105 (JP)
(74) Representative: Ritter und Edler von Fischern, Bernhard,Dipl.-Ing.

(56) References cited:
- US-A- 3 849 872
- IBM TECHNICAL DISCLOSURE BULLETIN. vol. 13, no. 7, December 1970, NEW YORK US page 1793; D.E. SHULTIS: 'SEMICONDUCTOR WAFER TESTING'
- IBM TECHNICAL DISCLOSURE BULLETIN. vol. 15, no. 9, February 1973, NEW YORK US pages 2681 - 2682; R. BOVE ET.AL.: 'IMPEDANCE TERMINATOR FOR AC TESTING MONOLITHIC CHIPS'

## Description

The present invention relates to a semiconductor wafer and, in particular, a semiconductor wafer having an IC (integrated circuit) pattern formed there.

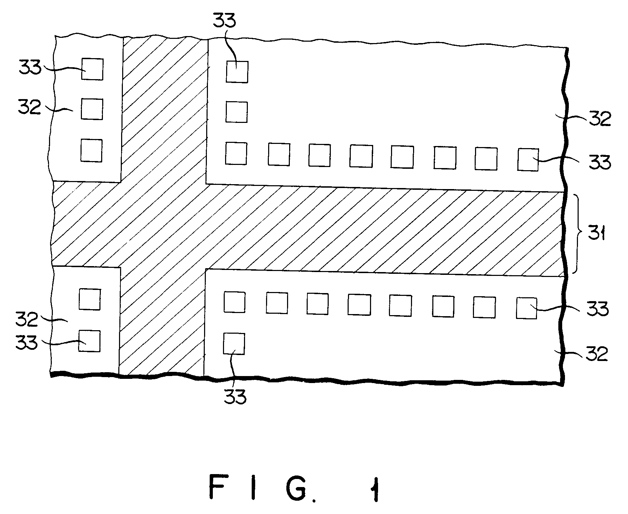

Fig. 1 shows a portion of a conventional semiconductor wafer having an IC pattern formed there. In Fig. 1, reference number 31 shows a dicing line area; reference number 32 shows a plurality of chip areas into which a wafer is divided by the dicing line area 31; and reference number 33 shows a plurality of pads formed over the respective chip area 32.

During the manufacture of a semiconductor integrated circuit, a die-sort testing has been done with the measuring terminals (probe needles) of a die-sort machine's probe card, not shown, placed in contact with corresponding pads 33 on the chip areas 32 so as to examine the whole function of the IC chips on the semiconductor wafer.

If the chip areas 32 each have a larger number of output pads 33 formed thereon, the same number of measuring terminals are required on the probe card of the die-sort machine for use in the die-sort test, that is, many measuring terminals are necessary in this case. For this reason, it becomes very difficult to product a corresponding probe card. Further, the number of, for example, relay switches is remarkably increased in the die-sort machine, requiring a very complex, expensive die-sort machine.

With a recent technological progress, a higher packing density IC pattern and smaller IC chip size have been seen as a recent trend. For a semiconductor circuit chip having a larger number of pads, the pad size and pitch become smaller and smaller. For this reason, the probe needles on the die-sort machine's probe card become correspondingly miniaturized and difficulty is encountered in placing the probe needles in contact with the corresponding pads. It takes a longer time to perform such an operation and hence to perform a die-sort testing.

US-A-3 849 872 discloses a test system for selectively accessing mechanically difficult to access terminals in an IC chip on a semiconductor wafer.

An object of the present invention is to provide a semiconductor wafer which allows an easier die-sort testing to be done even for semiconductor circuit chips having a larger number of pads and which can achieve less complicated die-sort machines at less equipment cost.

Another object of the present invention is to provide a semiconductor wafer which allows a latitude to be given to the pad size and pad pitch of a semiconductor circuit chip.

Another object of the present invention is to provide a semiconductor wafer which ensures a readiness with which measuring terminals on a die-sort machine's probe card are placed in contact with the corresponding pads for die-sort testing.

Another object of the present invention is to provide a semiconductor wafer which can shorten a time required for a die-sort testing.

These objects and advantages of the present invention can be achieved by the semiconductor wafer as will be set out below.

According to the present invention, there is provided a semiconductor wafer as given in claim 1.

This invention can be more fully understood from the following detailed description when taken in conjunction with the accompanying drawings, in which:
Fig. 1 is a pattern diagram showing a portion of a conventional semiconductor wafer;
Fig. 2 is a pattern diagram showing a portion of a semiconductor wafer according to an embodiment of the present invention; and
Fig. 3 is a pattern diagram showing a state in which the semiconductor wafer shown in Fig. 2 is divided by a dicing line area into individual integrated circuit chip areas.

One embodiment of the present invention will be explained below with reference to the accompanying drawings.

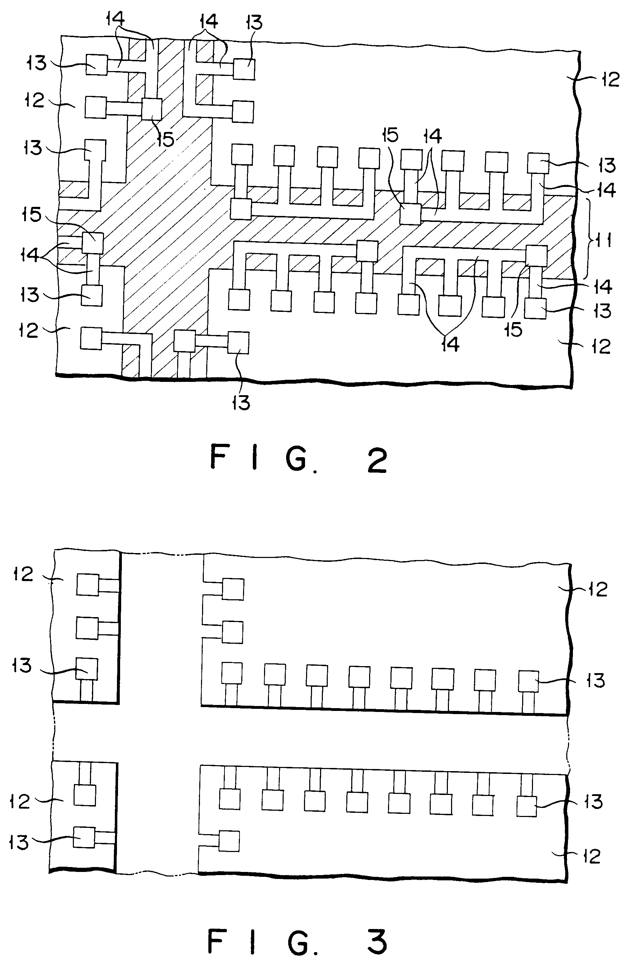

Fig. 2 shows a portion of a semiconductor wafer with an integrated circuit pattern formed thereon. In the semiconductor wafer, reference number 11 shows a dicing line area; reference number 12 shows chip areas into which the semiconductor wafer is divided by the dicing line area 11; and reference number 13 shows pads (for example, output pads) formed on the respective chip area 12. Here, on at least one of the chip areas 12, a predetermined IC pattern is formed having an output switching control circuit for selectively supplying output signals to corresponding output pads. Those output pads selectively supplied with output signals are commonly connected by the connection pattern 14. The connection pattern 14 is formed primarily on the dicing line area 11 and extends from the dicing line area 11 onto the respective output pads 13. A testing pad 15 is provided which is electrically connected to the connection pattern 14 on the dicing line area 11.

For a predetermined IC pattern formed on the chip area 12 on the semiconductor wafer, a die-sort testing measures the chip by placing the die-sort machine probe card's probe needle tip in contact with the testing pad 15. That is, with the probe needle connected to the testing pad 15, output is sequentially and selectively supplied by the switching circuit to the respective output pads in the respective set and output is transmitted from the testing pad 15 to the probe needle via the connection pattern 14. Since one testing pad 15 is connected to the plurality of pads 13, it can be used as a common testing pad and can be made larger in size than the pad 13 in the chip area 12. Further, as the connection patterns and testing pads are formed on the dicing line area, the pad size and pad pitch of the testing pads 15 on the dicing line area 11 can be set as large as possible so long as the width of the dicing line area permits.

It is, therefore, possible to achieve the readiness with which the measuring terminal of the die-sort machine's probe card is placed in contact with the testing pad and to enhance a yield at the die sort test. Further, it is not necessary to switch testing contacts by relay switches, causing no mechanical chattering at the contacts. Since no chattering delay time is given to a test program, a time required can be shortened. In the embodiment shown, one testing pad 15 is provided for one set of four pads and the test is conducted with the measuring terminal of the probe card contacted with the testing pad. It is only necessary to provide the same number of measuring terminals as that of the testing pads 15, that is, to provide the number of measuring terminals one-fourth that of the pads. It is thus possible to decrease the number of measuring terminals on the probe card and to readily product a probe card. Further, even in the case where the pads 13 are provided on the chip area in greater number and/or in high density, a conventional die-sort machine can be used as it is, allowing the use of less complex die-sort machine at less equipment cost.

Fig. 3 is a pattern diagram partially showing individual chip areas which are divided by a dicing line area after it is subjected to a die-sort testing. Since connection pattern 14 and testing pad 15 on the dicing line area are all removed, no inconvenience is encountered when the individual IC chips are produced as products.

Although, in the aforementioned embodiment, one testing pad has been explained as being used for four pads, it can be employed for less than or greater than the four pads.

## Claims

1. A semiconductor wafer divided into a plurality of chip areas (12) by dicing line areas (11), each of said chip areas having a predetermined integrated circuit pattern and at least one of said plurality of chip areas (12) having a plurality of sets of output pads (13), wherein said at least one of said chip areas has in addition an output switching control circuit for selectively and sequentially supplying output signals to output pads within a respective set of output pads, each set of output pads having further associated with it:
- a connection pattern (14) formed on the dicing line area (11) and commonly connecting together the pads (13) in the set of output pads, said connection pattern (14) extending from the output pads onto the dicing line area (11); and
- a testing pad (15) formed on the dicing line area (11) and connected to said connection pattern (14).

## Patentansprüche

1. Halbleiterwafer, der in einer Vielzahl von Chipbereichen (12) aufgeteilt ist durch Schneidlinien-Bereiche (11), wobei jeder der Chipbereiche ein vorbestimmtes Muster einer integrierten Schaltung aufweist, und wenigstens einer der Vielzahl von Chipbereichen (12) eine Vielzahl von Sätzen von Ausgangs-Anschlußflecken (13) hat, wobei der wenigstens eine der Chipbereiche zusätzlich einen Ausgangs-Umschalt-Steuerschaltkreis zum selektiven und sequentiellen Zuführen von Ausgangssignalen zu Ausgangs-Anschlußflecken innerhalb eines jeweiligen Satzes von Ausgangs-Anschlußflecken hat, wobei jeder Satz von Ausgangs-Anschlußflecken weiterhin verbunden ist mit:
- einem Verbindungsmuster (14), das auf dem Schneidlinien-Bereich (11) ausgebildet ist und die Anschlußflecken (13) in dem Satz von Ausgangs-Anschlußflecken miteinander gemeinsam verbindet, wobei sich das Verbindungsmuster (14) von den Ausgangs-Anschlußflecken auf den Schneidlinien-Bereich (11) erstreckt; und
- einem Test-Anschlußflecken (15), der auf dem Schneidlinien-Bereich (11) ausgebildet ist und mit dem Verbindungsmuster (14) verbunden ist.

## Revendications

1. Pastille de semi-conducteur divisée en une pluralité de zones de composant (12) par des zones de ligne de quadrillage (11), chacune desdites zones de composant possédant une configuration prédéterminée de circuit intégré et au moins une parmi ladite pluralité de zones de composant (12) possédant une pluralité d'ensembles de plots de sortie (13), pastille dans laquelle au moins ladite zone desdites zones de composant possède, de plus, un circuit de commande de commutation de sortie pour fournir, de façon sélective et séquentielle, des signaux de sortie vers les plots de sortie d'un ensemble respectif de plots de sortie, chaque ensemble de plots de sortie possédant, de plus, en association :
- une configuration de raccordement (14) formée sur la zone de ligne de quadrillage (11) et raccordant en commun les plots (13) de l'ensemble de plots de sortie, ladite configuration de raccordement (14) s'étendant des plots de sortie sur la zone de ligne de quadrillage (11); et
- un plot de test (15) formé sur la zone de ligne de quadrillage (11) et raccordé à ladite configuration de raccordement (14).
